# EUROPEAN PATENT APPLICATION

(11) **EP 4 531 087 A1**
(43) Date of publication of application: **02.04.2025**
(21) Application number: 24202856.1
(22) Date of filing: 26.09.2024
(51) Int. Cl.: H01L 21/768, H01L 23/532

(54) **INTERCONNECT STRUCTURE, METHOD OF MANUFACTURING SAME, AND ELECTRONIC DEVICE INCLUDING SAME**

(30) Priority: 27.09.2023 KR 20230131069
(71) Applicant: Samsung Electronics Co., Ltd, Suwon-si, Gyeonggi-do 16677 (KR)
(72) Inventor: JO, Giyoung, 16678 Suwon-si (KR); KIM, Sangwon, 16678 Suwon-si (KR); KIM, Jaewon, 16678 Suwon-si (KR); SHIN, Hyeon Jin, 16678 Suwon-si (KR); VAN LUAN, Nguyen, 16678 Suwon-si (KR); LEE, Chang Seok, 16678 Suwon-si (KR)
(74) Representative: Elkington and Fife LLP

(57) **Abstract**

Disclosed is an interconnect structure including a substrate, a conductive layer on the substrate, and a passivation layer in contact with the conductive layer, where the passivation layer includes a first layer including boron nitride (h-BN) having a hexagonal crystal structure and a second layer including amorphous boron nitride (a-BN), and the first layer is in contact with the conductive layer.

## Description

### FIELD OF THE INVENTION

The present disclosure relates to an interconnect structure, a method for manufacturing the same, and an electronic device including the same.

### BACKGROUND OF THE INVENTION

To provide high-density, high-performance semiconductor devices, efforts to reduce the line width or thickness of metal wiring are continuing. By reducing the line width or thinning the thickness of metal wiring, the number of semiconductor chips integrated per wafer can be increased. Additionally, when the thickness of the metal wiring is thinned, the capacitance of the line can be reduced, and thus the speed of the signal passing through the wiring can be increased.

However, as the line width or thickness of the metal wiring decreases, the resistance increases rapidly, and thus reducing the resistance of the metal wiring becomes more important than anything else. Current wiring technology has a problem in that resistivity increases significantly due to grain-boundary scattering and/or surface-roughness scattering as line widths are significantly reduced.

Additionally, since deterioration may occur due to oxidation occurring at the metal/oxide interface or exposed metal surface, a technology to reduce the resistance of the wiring structure while preventing metal oxidation is desirable.

### SUMMARYOF THE INVENTION

An embodiment provides an interconnect structure that can prevent oxidation of metal wiring while reducing an increase in resistance due to a decrease in line width of the metal wiring.

An embodiment provides a method of manufacturing the interconnect structure.

An embodiment provides an electronic device including the interconnect structure.

According to an embodiment, an interconnect structure includes a substrate; a conductive layer on the substrate; and a passivation layer in contact with the conductive layer, where the passivation layer includes a first layer including boron nitride (h-BN) having a hexagonal crystal structure and a second layer including amorphous boron nitride (a-BN), and the first layer is in contact with the conductive layer.

The passivation layer may be disposed on at least one of an upper surface or a lower surface of the conductive layer.

The conductive layer may include a metal, a metal alloy, a conductive compound, or a combination thereof.

The metal may include a transition metal, a Group 2A metal, a Group 3A (Group 13) metal, or a combination thereof.

The conductive layer may include copper (Cu), ruthenium (Ru), aluminum (Al), cobalt (Co), tungsten (W), molybdenum (Mo), titanium (Ti), tantalum (Ta), nickel (Ni), platinum (Pt), chromium (Cr), rhodium (Rh), iridium (Ir), palladium (Pd), osmium (Os), gold (Au), niobium (Nb), vanadium (V), scandium (Sc), erbium (Er), lanthanum (La), or a combination thereof.

The metal alloy may include NiCo, NiAl, CoMo, RuMo, NbV, TaNb, VsCr, VsMo, Er₂Ni₇, FeCos, LaCu₁₃, FeNi, FeRu, BeCo, TaV, CrNi, TiV, ZrNb, MoRu, MoRus, MosRu, or a combination thereof.

The conductive compound may include a metal nitride, a metal phosphide, a metal arsenide or a combination thereof.

The conductive layer may have a thickness of less than or equal to about 10 nanometers (nm), and the passivation layer may have a thickness of less than or equal to about 30 nm.

A thickness ratio of the conductive layer and passivation layer may be in a range of about 1 :0.01 to about 1:3.

The passivation layer may further include a third layer including a dielectric on a surface of the second layer that does not contact the first layer.

The hexagonal boron nitride (h-BN) included in the first layer may be derived from amorphous boron nitride (a-BN) included in the second layer.

The hexagonal boron nitride (h-BN) included in the first layer may form van der Waals bonds with a material constituting the conductive layer.

The first layer may have a thickness of less than or equal to about 3 nm, and the second layer may have a thickness of less than or equal to about 25 nm.

A thickness ratio of the first layer and the second layer may be in a range of about 1:1.5 to about 1:8.

The first layer may be formed as a continuous layer on the surface in contact with the conductive layer.

A barrier layer may further be included between the substrate and the conductive layer or between the substrate and the passivation layer.

The interconnect structure may include the substrate, which includes a dielectric layer defining a trench structure therein, the conductive layer, which fills the interior of the trench structure, and the passivation layer, which is disposed on an upper surface of the conductive layer.

The interconnect structure may include the substrate, which includes a dielectric layer defining a trench structure therein, the conductive layer, which fills the interior of the trench structure, and the passivation layer, which is disposed on a lower surface and side surfaces of the conductive layer.

The interconnect structure may include the substrate, which includes a dielectric layer defining a trench structure therein, the conductive layer, which fills the interior of the trench structure, and the passivation layer, which surrounds the entire conductive layer.

At least one surface inside the trench structure may further include a barrier layer.

The barrier layer may include a metal, an alloy of a metal, a metal oxide, a metal nitride or a combination thereof.

According to another embodiment, a method for manufacturing an interconnect structure includes: forming a conductive layer on a substrate; forming a dielectric layer including amorphous boron nitride (a-BN) on the conductive layer; and converting amorphous boron nitride (a-BN) present at an interface between the dielectric layer and the conductive layer into hexagonal boron nitride (h-BN) to form a passivation layer including a first layer including the hexagonal boron nitride (h-BN) and a second layer including amorphous boron nitride (a-BN).

According to another embodiment, a method of manufacturing the interconnect structure includes forming a dielectric layer including amorphous boron nitride (a-BN) on a substrate; forming a conductive layer on the dielectric layer; and converting amorphous boron nitride (a-BN) present at the interface between the dielectric layer and the conductive layer into hexagonal boron nitride (h-BN) to form a passivation layer including a first layer including the hexagonal boron nitride (h-BN) and a second layer including amorphous boron nitride (a-BN).

The passivation layer may be formed by a process of locally applying energy to amorphous boron nitride (a-BN) included in the dielectric layer to convert it into the hexagonal boron nitride (h-BN) included in the first layer.

The energy application process may include annealing, laser irradiation, or a combination thereof.

Another embodiment provides an electronic device including the interconnect structure.

The electronic device may be a transistor, a capacitor, a diode, or a resistor.

The interconnect structure can effectively reduce the increase in resistance due to grain-boundary scattering and/or surface-roughness scattering by a decrease in the line width of the metal wiring (e.g., conductive layer).

### BRIEF DESCRIPTION OF THE DRAWINGS

FIGS. 1 to 3 are cross-sectional views of interconnect structures according to some example embodiments.
FIGS. 4 to 9 are cross-sectional views of interconnect structures according to some example embodiments.
FIG. 10 is a cross-sectional view of an interconnect structure according to an embodiment.
FIGS. 11 and 12 are cross-sectional views of electronic devices according to some example embodiments.
FIG. 13 is a graph showing the results of Raman spectrum evaluations to confirm the formation of hexagonal boron nitride in structures according to Examples 1 to 3 and Comparative Example 1.

### DETAILED DESCRIPTION

Hereinafter, example embodiments of the present disclosure will be described in detail so that a person skilled in the art would understand the same. This disclosure may, however, be embodied in many different forms and is not construed as limited to the example embodiments set forth herein.

The terminology used herein is used to describe embodiments only and is not intended to limit the present disclosure. The singular expression includes the plural expression unless the context clearly dictates otherwise.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer, or section from another element, component, region, layer, or section. Thus, "a first element," "component," "region," "layer," or "section" discussed below could be termed a second element, component, region, layer, or section without departing from the teachings herein. The terminology used herein is for the purpose of describing particular embodiments only and is not intended to be limiting. As used herein, the singular forms "a," "an," and "the" are intended to include the plural forms, including "at least one," unless the content clearly indicates otherwise. Thus, reference to "an" element in a claim followed by reference to "the" element is inclusive of one element and a plurality of the elements. "At least one" is not to be construed as limiting "a" or "an." "Or" means "and/or." As used herein, the term "and/or" includes any and all combinations of one or more of the associated listed items.

As used herein, terms such as "comprise," "comprise," or "have" are intended to designate the presence of implemented features, numbers, steps, components, or a combination thereof, but not one or more other features, numbers, steps, components, or combinations thereof should be understood as not excluding in advance the existence or possibility of addition.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it can be directly on the other element or intervening elements may also be present. In contrast, when an element is referred to as being "directly on" another element, there are no intervening elements present. In contrast, when an element is referred to as being "directly on" another element, there are no intervening elements present.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 10%, ±5%, ±3%, or ±1 % of the stated value.

Relative terms, such as "downward," "lower," or "bottom," and "upward," "upper," or "top," may be used herein to describe one element's relationship to another element as illustrated in the drawings. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Example embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, "layer" herein includes not only a shape formed on the whole surface when viewed from a plan view, but also a shape formed on a partial surface.

The use of the term "the" and similar referential terms may refer to both the singular and the plural. Unless the order of the steps constituting the method is clearly stated or stated to the contrary, these steps may be performed in any appropriate order and are not necessarily limited to the order described.

In addition, terms such as "... unit" and "module" used in the specification refer to a unit that processes at least one function or operation, which may be implemented as hardware or software, or as a combination of hardware and software.

The connections or connection members of lines between components shown in the drawings exemplify functional connections and/or physical or circuit connections, and in actual devices, may be represented as various functional connections, physical connections, or circuit connections.

As used herein, "at least one of A, B or C," "one of A, B, C, or a combination thereof" and "one of A, B, C, and a combination thereof" refer to each component and refers to any combination (e.g., A; B; C; A and B; A and C; B and C; or A, B, and C).

Herein, "a combination thereof" means a mixture of components, a laminate, a composite, an alloy, a blend, and the like.

Herein, "metal" is interpreted as a concept that includes metals and metalloids (semimetals).

Hereinafter, an interconnect structure according to an embodiment will be described with reference to the attached drawings.

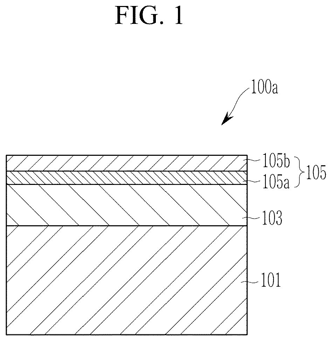

FIGS. 1 to 3 are cross-sectional views of interconnect structures according to some example embodiments.

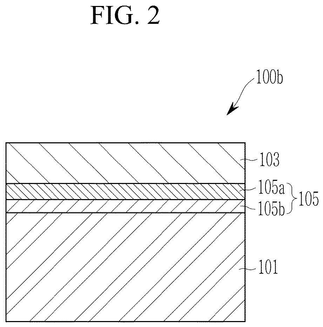

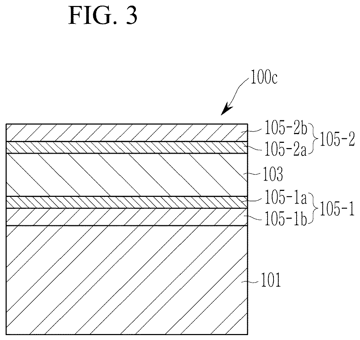

Referring to FIGS. 1 and 2, the interconnect structures 100a and 100b include a substrate 101, a conductive layer 103 on the substrate 101, and a passivation layer 105 that is in contact with the conductive layer 103 and referring to FIG. 3, the interconnect structure 100c includes a substrate 101, a conductive layer 103 on the substrate 101, and passivation layers 105-1 and 105-2 that are in contact with the conductive layer 103.

The passivation layer 105 includes a first layer 105a including hexagonal boron nitride (h-BN) and a second layer 105b including amorphous boron nitride (a-BN). The first layer 105a may not include amorphous boron nitride (a-BN).

The passivation layer 105 may be disposed on an upper surface, a bottom surface, or both of the conductive layer 103.

FIG. 1 shows a structure in which the passivation layer 105 is located on the upper surface of the conductive layer 103, FIG. 2 shows a structure in which the passivation layer 105 is formed on the lower surface of the conductive layer 103, that is, between the substrate 101 and the conductive layer 103, and FIG. 3 shows a structure in which the passivation layers 105-1 and 105-2 are formed on both the upper and lower surfaces of the conductive layer 103.

The substrate 101 may include at least one of a Group IV semiconductor material, a semiconductor compound (e.g., a Group III-V compound semiconductor, or a Group II-VI compound semiconductor), an insulator, or a metal. For example, the substrate 101 may include a Group IV semiconductor material such as Si, Ge, or Sn. For another example, the substrate 101 may include at least one of Si, Ge, C, Zn, Cd, Al, Ga, In, B, N, P, S, Se, As, Sb, Te Ta, Ru, Rh, Ir, Co, Ti, W, Pt, Au, Ni, or Fe. For another example, the substrate 101 may include Si, Ge, SiC, SiGe, SiGeC, Ge alloy, GaAs, InAs, InP, etc. The substrate may include a single layer or multiple layers of different materials stacked.

For example, the substrate 101 may include a Silicon-On-Insulator ("SOI") substrate or a Silicon Germanium-On-Insulator ("SGOI") substrate. For example, the substrate may further include N or F in a SiCOH-based composition and may also include pores to lower the dielectric constant. Meanwhile, the substrate 101 may further include a dopant.

The conductive layer 103 may include a metal, a metal alloy, a conductive compound, or a combination thereof.

The metal may include a transition metal, a Group 2A metal, a Group 3A (Group 13) metal, or a combination thereof.

The metal may include copper (Cu), ruthenium (Ru), aluminum (Al), cobalt (Co), tungsten (W), molybdenum (Mo), titanium (Ti), tantalum (Ta), nickel (Ni), platinum (Pt), chromium (Cr), rhodium (Rh), iridium (Ir), palladium (Pd), osmium (Os), gold (Au), niobium (Nb), vanadium (V), scandium (Sc), erbium (Er), lanthanum (La), or a combination thereof.

The metal alloy may include NiCo, NiAl, CoMo, RuMo, NbV, TaNb, VsCr, VsMo, Er₂Ni₇, FeCos, LaCu₁₃, FeNi, FeRu, BeCo, TaV, CrNi, TiV, ZrNb, MoRu, MoRus, MosRu or a combination thereof.

The conductive compound may include a metal nitride, a metal phosphide, a metal arsenide or a combination thereof. For example, the conductive compound may include titanium nitride (TiN), tantalum nitride (TaN), ruthenium nitride (RuN), tungsten nitride (WN), aluminum nitride (AIN), iridium tantalum nitride (IrTaN), titanium silicon nitride (TiSiN), niobium nitride (NbN), molybdenum nitride (MoN), molybdenum phosphide (MoP), niobium arsenide (NbAs), and the like.

The conductive layer 103 may have a single crystal structure.

The conductive layer 103 may have a thickness of less than or equal to about 10 nm, for example, less than or equal to about 9 nm, less than or equal to about 8 nm, less than or equal to about 7 nm, less than or equal to about 6 nm, and greater than or equal to about 0.1 nm. Within the above range, it is possible to provide a nanoscale wiring structure.

The passivation layer 105, 105-1, or 105-2 may have a thickness of less than or equal to about 30 nm, for example, less than or equal to about 25 nm, less than or equal to about 20 nm, less than or equal to about 15 nm, less than or equal to about 10 nm, less than or equal to about 9 nm, less than or equal to about 8 nm, less than or equal to about 7 nm, or less than or equal to about 6 nm and may have a thickness of greater than or equal to about 0.1 nm. Within the above range, oxidation of the conductive layer 103 may be prevented while suppressing grain-boundary scattering and/or surface-roughness scattering effects, thereby preventing a rapid increase in resistance.

The thickness ratio of the conductive layer 103 and the passivation layer 105, 105-1, or 105-2 may be in the range of about 1:0.01 to about 1:3. The ratio of the thickness of the passivation layer 105, 105-1, or 105-2 to the conductive layer 103 may be, for example, greater than or equal to about 0.01, greater than or equal to about 0.02, greater than or equal to about 0.03, greater than or equal to about 0.04, greater than or equal to about 0.05, greater than or equal to about 0.06, greater than or equal to about 0.07, greater than or equal to about 0.08, greater than or equal to about 0.09, greater than or equal to about 0.1, greater than or equal to about 0.2, greater than or equal to about 0.3, greater than or equal to about 0.4, or greater than or equal to about 0.5, and may be less than or equal to about 2.9, less than or equal to about 2.7, less than or equal to about 2.6, less than or equal to about 2.5, less than or equal to about 2.4, less than or equal to about 2.2, less than or equal to about 2.0, less than or equal to about 1.9, less than or equal to about 1.7, less than or equal to about 1.6, less than or equal to about 1.5, less than or equal to about 1.4, less than or equal to about 1.3, less than or equal to about 1.2, less than or equal to about 1.1, less than about 1, or less than or equal to about 1. Additionally, the ratio of the thickness of the passivation layer 105, 105-1, or 105-2 to the conductive layer 103 may be within a range combining the above numerical ranges (e.g., about 0.01 to about 1.9).

The conductive wiring configured to have a heterogeneous structure of the conductive layer 103 and the passivation layer 105, 105-1, or 105-2 can prevent an increase in electrical resistance due to a decrease in the wiring line width and reduce or prevent defects in the wiring due to electromigration. The passivation layer 105, 105-1, or 105-2 may serve as a barrier layer to prevent the material of the conductive layer 103 from diffusing.

Referring to FIGS. 1 and 2, the passivation layer 105includes a first layer 105a including hexagonal boron nitride (h-BN) and a second layer 105b including amorphous boron nitride (a-BN), and the first layer 105a is arranged to be in contact with the conductive layer 103. The first layer 105a may not include amorphous boron nitride (a-BN). Referring to FIG. 3, a first passivation layer 105-1 is formed on the lower surface of the conductive layer 103, a second passivation layer 105-2 is formed on the upper surface of the conductive layer 103, and these first and second passivation layers 105-1 and 105-2 include first layers 105-1a and 105-2a including hexagonal boron nitride (h-BN) and second layers 105-1b and 105-2b including amorphous boron nitride (a-BN), and the first layers 105-1a and 105-2a are in contact with the conductive layer 103.

The hexagonal boron nitride (h-BN) included in the first layer 105a may be derived from amorphous boron nitride (a-BN) included in the second layer 105b.

Conventionally, hexagonal boron nitride (h-BN) is formed by depositing precursor materials (e.g., borazine) at high temperatures, but this high-temperature deposition process may have a negative effect on the materials that constitute the device, which reduces the efficiency of the device. Therefore, in an embodiment, instead of a high-temperature deposition process, amorphous boron nitride (a-BN) is used as a precursor, and a metal included in the conductive layer 103 is used as a catalyst to convert amorphous boron nitride (a-BN) into hexagonal boron nitride (h-BN) at relatively low temperature to form a passivation layer 105. That is, a passivation layer 105 capable of preventing grain-boundary scattering and/or surface-roughness scattering effects can be formed through a low-temperature process, thereby suppressing or reducing scattering effects that cause signal transmission delays through a simple process without affecting the performance of the device. The process for converting amorphous boron nitride (a-BN) into hexagonal boron nitride (h-BN) is described below.

The hexagonal boron nitride (h-BN) included in the first layer 105a has a hexagonal crystal structure and can form a van der Waals bond with the wiring material constituting the conductive layer 103, thereby reducing the overlapping electron density at the interface with the conductive layer 103 and can act as an interface control material that suppresses or reduces the grain boundary scattering and/or surface-roughness scattering effect of the wiring material of the conductive layer 103 at the interface with the conductive layer 103. This can effectively improve the signal transmission delay problem in the wiring structure.

The first layers 105a, 105-1a, and 105-2a may have a thickness of less than or equal to about 3 nm, for example, less than or equal to about 2.9 nm, less than or equal to about 2.8 nm, less than or equal to about 2.7 nm, less than or equal to about 2.6 nm, less than or equal to about 2.5 nm, less than or equal to about 2.4 nm, less than or equal to about 2.3 nm, less than or equal to about 2.2 nm, less than or equal to about 2.1 nm, or less than or equal to about 2.0 nm and may have a thickness of greater than or equal to about 0.1 nm, for example, greater than or equal to about 0.2 nm, greater than or equal to about 0.3 nm, greater than or equal to about 0.4 nm, greater than or equal to about 0.5 nm, greater than or equal to about 0.6 nm, greater than or equal to about 0.7 nm, greater than or equal to about 0.8 nm, greater than or equal to about 0.9 nm, or greater than or equal to about 1.0 nm. Additionally, the thickness of the first layers 105a, 105-1a, and 105-2a may be within a range combining the above numerical ranges (e.g., about 0.1 nm to about 3 nm).

The second layers 105b, 105-1b, and 105-2b may have a thickness of less than or equal to about 25 nm, for example, less than or equal to about 20 nm, less than or equal to about 18 nm, less than or equal to about 16 nm, less than or equal to about 15 nm, less than or equal to about 12 nm, less than or equal to about 10 nm, less than or equal to about 8 nm, less than or equal to about 7 nm, less than or equal to about 6 nm, less than or equal to about 5 nm, less than or equal to about 4.9 nm, less than or equal to about 4.8 nm, less than or equal to about 4.7 nm, less than or equal to about 4.6 nm, less than or equal to about 4.5 nm, less than or equal to about 4.4 nm, less than or equal to about 4.3 nm, less than or equal to about 4.2 nm, less than or equal to about 4.1 nm or less than or equal to about 4.0 nm and greater than or equal to about 0.5 nm, for example, greater than or equal to about 0.6 nm, greater than or equal to about 0.7 nm, greater than or equal to about 0.8 nm, greater than or equal to about 0.9 nm, greater than or equal to about 1.0 nm, greater than or equal to about 1.1 nm, greater than or equal to about 1.2 nm, greater than or equal to about 1.3 nm, greater than or equal to about 1.4 nm, or greater than or equal to about 1.5 nm. Additionally, the thickness of the second layers 105b, 105-1b, and 105-2b may be within a range combining the above numerical ranges (e.g., about 0.5 nm to about 9 nm).

The thickness ratio of the first layers 105a, 105-1a, and 105-2a and the second layers 105b, 105-1b, and 105-2b may be in a range of about 1:1.5 to about 1:8. The thickness ratio of the second layers 105b, 105-1b, and 105-2b to the first layers 105a, 105-1a, and 105-2a may be, for example, greater than or equal to about 1.5, greater than or equal to about 1.6, greater than or equal to about 1.7, greater than or equal to about 1.8, greater than or equal to about 1.9, or greater than or equal to about 2.0, and may be less than or equal to about 8.0, less than or equal to about 7.0, less than or equal to about 6.0, less than or equal to about 5.0, less than or equal to about 4.0, less than or equal to about 3.5, , less than or equal to about 3.0, less than or equal to about 2.9, less than or equal to about 2.8, less than or equal to about 2.7, less than or equal to about 2.6, or less than or equal to about 2.5. Additionally, the thickness ratio of the second layers 105b, 105-1b, and 105-2b to the first layers 105a, 105-1a, and 105-2a may be within a range combining the above numerical ranges (e.g., about 1.5 to about 8).

In FIGS. 1 to 3, the passivation layers 105, 105-1, and 105-2 are depicted as having a two-layer structure in which first layers 105a, 105-1a, and 105-2a and second layers 105b, 105-1b, and 105-2b are stacked, but a multilayer structure of three or more layers may also be possible.

In an embodiment, the passivation layers 105, 105-1, and 105-2 may further include a third layer (not shown) that includes a dielectric on a surface of the second layer 105b that does not contact the first layer 105a.

The third layer may include an inorganic oxide, and specifically may include Al₂O₃, AlN, ZrO₂, HfOₓ (0<x≤2), SiO₂, SiCO, SiCN, SiON, SiCOH, AlSiO, or a combination thereof.

The third layer may have a thickness of less than or equal to about 20 nm, less than or equal to about 18 nm, less than or equal to about 16 nm, less than or equal to about 15 nm, less than or equal to about 12 nm, less than or equal to about 10 nm, less than or equal to about 8 nm, less than or equal to about 7 nm, less than or equal to about 6 nm, less than or equal to about 5 nm, less than or equal to about 4.9 nm, less than or equal to about 4.8 nm, less than or equal to about 4.7 nm, less than or equal to about 4.6 nm, less than or equal to about 4.5 nm, less than or equal to about 4.4 nm, less than or equal to about 4.3 nm, less than or equal to about 4.2 nm, less than or equal to about 4.1 nm, or less than or equal to about 4.0 nm, and may have a thickness of greater than or equal to about 0.5 nm, for example, greater than or equal to about 0.6 nm, greater than or equal to about 0.7 nm, greater than or equal to about 0.8 nm, greater than or equal to about 0.9 nm, greater than or equal to about 1.0 nm, greater than or equal to about 1.1 nm, greater than or equal to about 1.2 nm, greater than or equal to about 1.3 nm, greater than or equal to about 1.4 nm, or greater than or equal to about 1.5 nm.

Since the above hexagonal boron nitride (h-BN) is formed by conversion from amorphous boron nitride (a-BN), which is a dielectric material, a passivation layer 105 may be formed without reducing the area of the conductive layer 103.

In an interconnect structure according to an embodiment, since a passivation layer 105 is formed in contact with a conductive layer 103, there is no need for a separate barrier layer to prevent diffusion of a material of the conductive layer 103 or a liner layer to improve the adhesive strength of the conductive layer 103.

However, in another embodiment, a barrier layer may be further included between the substrate 101 and the conductive layer 103 or between the substrate 101 and the passivation layer 105. As described above, since the passivation layer 105 may function as a barrier layer, the barrier layer may not be included.

The barrier layer may include a metal, an alloy of a metal, a metal oxide, a metal nitride, or a combination thereof.

The barrier layer may prevent or reduce the materials of the conductive layer 103 and the passivation layer 105 from diffusing into the substrate 101. The barrier layer may have a multilayer structure in which a plurality of layers including different materials are stacked. For example, the barrier layer may include a first barrier layer in contact with the conductive layer 103 or the passivation layer 105 and a second barrier layer in contact with the substrate 101. The first barrier layer may include a metal or an alloy of metals and the second barrier layer may include a metal nitride or a metal oxide.

The metal that can be used in the barrier layer may be one of magnesium (Mg), aluminum (Al), scandium (Sc), titanium (Ti), vanadium (V), chromium (Cr), manganese (Mn), nickel (Ni), zinc (Zn), gallium (Ga), zirconium (Zr), niobium (Nb), molybdenum (Mo), lead (Pd), silver (Ag), cadmium (Cd), indium (In), tin (Sn), lanthanum (La), hafnium (Hf), tantalum (Ta), tungsten (W), iridium (Ir), platinum (Pt), gold (Au), bismuth (Bi), cobalt (Co), ruthenium (Ru), and a combination thereof. The metal alloy of the barrier layer may include RuTa, IrTa, etc.

The metal oxide of the barrier layer may be a compound represented by Chemical Formula 1.

[Chemical Formula 1] MₓO_{y}

In Chemical Formula 1,
M may be at least one of Mn, Al, Ti, Zr, Hf, Mg, Si, Ge, Y, Lu, La, Ta, or Sr, 0 < x ≤ 2, and 0 < y ≤ 3.

Examples of the metal oxide may include MnO, AlO_{z} (0<z≤3/2), TaO_{z} (0< z ≤5/2), TiO₂, ZrO₂, HfO₂, MgO, SiO₂, GeO₂, Y₂O₃, Lu₂O₃, La₂O₃, SrO, etc.

The metal nitride of the barrier layer may include tantalum nitride (TaN), titanium nitride (TiN), ruthenium nitride (RuN), tungsten nitride (WN), aluminum nitride (AlN), IrTaN, TiSiN, and the like.

A multilayer metal wiring structure including the above-mentioned conductive layer 103 and passivation layer 105 may be placed in a trench of the substrate 101.

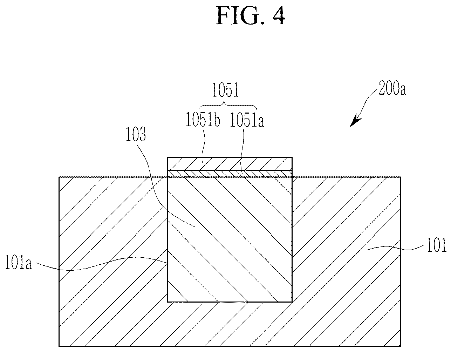

This structure is explained with reference to FIGS. 4 to 8. FIGS. 4 to 8 are cross-sectional views of interconnect structures according to some example embodiments.

Referring to FIG. 4, the interconnect structure 200a includes a conductive layer 103 filled inside a trench 101a of a substrate 101 and a passivation layer 1051 disposed on the upper surface of the conductive layer 103. The passivation layer 1051 includes a first layer 1051a including hexagonal boron nitride (h-BN) and a second layer 1051b including amorphous boron nitride (a-BN), and the first layer 1051a is arranged to be in contact with the conductive layer 103. The first layer 1051a may not include amorphous boron nitride (a-BN).

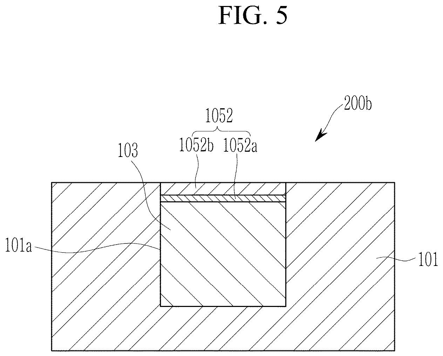

Referring to FIG. 5, the interconnect structure 200b has a conductive layer 103 inside a trench 101a of a substrate 101 and a passivation layer 1052 on the upper surface of the conductive layer 103 and inside the trench 101a of the substrate 101. The passivation layer 1052 includes a first layer 1052a including hexagonal boron nitride (h-BN) and a second layer 1052b including amorphous boron nitride (a-BN), and the first layer 1052a is arranged to be in contact with the conductive layer 103. The first layer 1052a may not include amorphous boron nitride (a-BN).

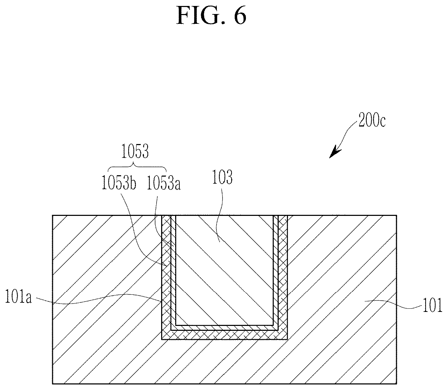

Referring to FIG. 6, the interconnect structure 200c includes a passivation layer 1053 present along the trench 101a of the substrate 101 and a conductive layer 103 located within the trench 101a. The passivation layer 1053 includes a first layer 1053a including hexagonal boron nitride (h-BN) and a second layer 1053b including amorphous boron nitride (a-BN), and the first layer 1053a is arranged to be in contact with the conductive layer 103. The first layer 1053a may not include amorphous boron nitride (a-BN).

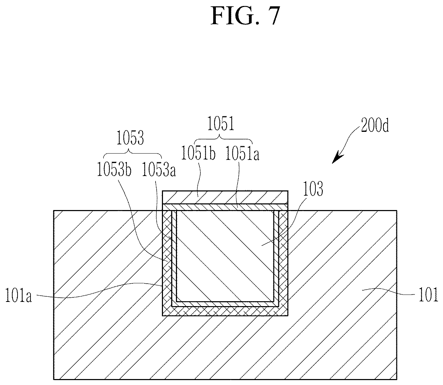

Referring to FIG. 7, the interconnect structure 200d has a first passivation layer 1053 located along the trench 101a of the substrate 101, a conductive layer 103 located within the trench, and a second passivation layer 1051 disposed on the upper surface of the conductive layer 103. The first passivation layer 1053 includes a first layer 1053a including hexagonal boron nitride (h-BN) and a second layer 1053b including amorphous boron nitride (a-BN), and the first layer 1053a is arranged to be in contact with the conductive layer 103. The second passivation layer 1051 includes a first layer 1051a including hexagonal boron nitride (h-BN) and a second layer 1051b including amorphous boron nitride (a-BN), and the first layer 1051a is arranged to be in contact with the conductive layer 103. The first layer 1051a may not include amorphous boron nitride (a-BN). The first passivation layer 1053 and the second passivation layer 1051 together may surround the entirety of the conductive layer 103.

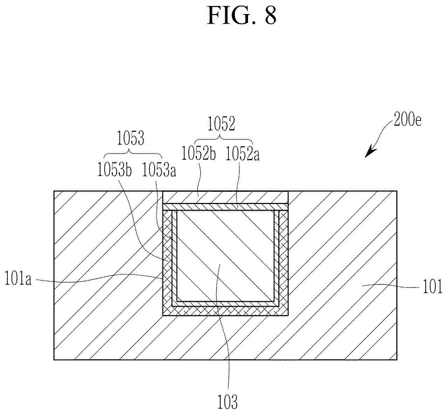

Referring to FIG. 8, the interconnect structure 200e includes a first passivation layer 1053 present along the trench 101a of the substrate 101, a conductive layer 103 buried within the trench, and a second passivation layer 1052 disposed on the upper surface of the conductive layer 103 and the first passivation layer 1053 and buried within the trench. The first passivation layer 1053 includes a first layer 1053a including hexagonal boron nitride (h-BN) and a second layer 1053b including amorphous boron nitride (a-BN), and the first layer 1053a is arranged to be in contact with the conductive layer 103. The second passivation layer 1052 includes a first layer 1052a including hexagonal boron nitride (h-BN) and a second layer 1052b including amorphous boron nitride (a-BN), and the first layer 1052a is arranged to be in contact with the conductive layer 103. The first layers 1053a and 1052a may not include amorphous boron nitride (a-BN). The first passivation layer 1053 and the second passivation layer 1052 together may surround the entirety of the conductive layer 103.

As a method for forming a trench in the substrate 101, a photolithography process and an etching process such as reactive ion etching ("RIE") may be used.

The substrate 101, the conductive layer 103, and the passivation layers 1051, 1052, and 1053 in FIGS. 5 to 8 are the same as the substrate 101, the conductive layer 103, and the passivation layers 105, 105-1, and 105-2 described in FIGS. 1 to 3, and thus their detailed descriptions are omitted.

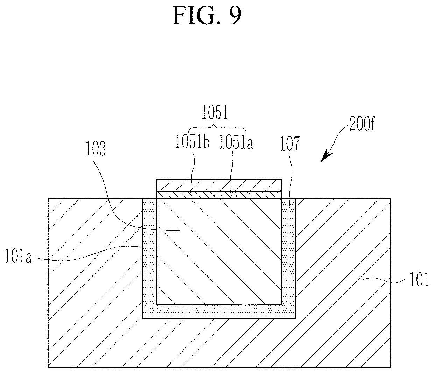

In the interconnect structure illustrated in FIGS. 5 to 8, a barrier layer may be located on the inner surface of the trench 101a. A structure in which a barrier layer is additionally included in the interconnect structure of FIG. 4 is illustrated in FIG. 9. FIG. 9 is a cross-sectional view of an interconnect structure according to an embodiment.

Referring to FIG. 9, the interconnect structure 200f includes a barrier layer 107 on opposite side surfaces and the lower surface of a trench 101a of a substrate 101, where the barrier layer 107 surrounds a conductive layer 103 inside the trench 101a, and a passivation layer 1051 is located on the upper surface of the conductive layer 103. The passivation layer 1051 includes a first layer 1051a including hexagonal boron nitride (h-BN) and a second layer 1051b including amorphous boron nitride (a-BN), and the first layer 1051a is arranged to be in contact with the conductive layer 103. The first layer 1051a may not include amorphous boron nitride (a-BN).

The barrier layer 107 may prevent or reduce the materials of the conductive layer 103 and the passivation layer 105 from diffusing into the substrate 101. The barrier layer 107 may have a multilayer structure in which multiple layers including different materials are stacked. For example, the barrier layer 107 may include a first barrier layer in contact with the conductive layer 103 or the passivation layer 105 and a second barrier layer in contact with the substrate 101. The first barrier layer may include a metal or an alloy of metals and the second barrier layer may include a metal nitride or a metal oxide. Specific examples of the metal, an alloy of metals, metal oxide, and metal nitride that can be used in the barrier layer are as described above.

The above describes an example in which a barrier layer is formed in the structure of FIG. 4, but the interconnect structure illustrated in FIGS. 5 to 8 may also have a barrier layer formed along the trench 101a of the substrate 101.

As described above, in the interconnect structures illustrated in FIGS. 6 to 8, the passivation layer can serve as a barrier layer, and thus the barrier layer may be omitted.

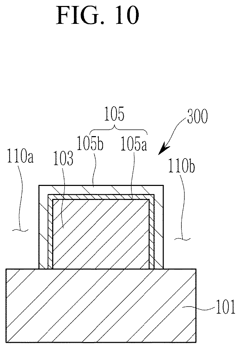

If the upper surface is a flat substrate, the multilayered wiring structure of the conductive layer and the passivation layer may have empty spaces on opposite sides. This structure is shown in FIG. 10. FIG. 10 is a cross-sectional view of an interconnect structure according to an embodiment.

Referring to FIG. 10, the interconnect structure 300 has a multilayered structure of a conductive layer 103 and a passivation layer 105 surrounding the conductive layer 103 on a substrate 101, and empty spaces 110a and 110b are formed on opposite sides of the multilayered structure. The passivation layer 105 includes a first layer 105a including hexagonal boron nitride (h-BN) and a second layer 105b including amorphous boron nitride (a-BN), and the first layer 105a is arranged to be in contact with the conductive layer 103. The first layer 105a may not include amorphous boron nitride (a-BN).

In FIG. 10, the empty spaces 110a and 110b may be filled with air, etc., and if the empty spaces 110a and 110b are air gaps filled with air, the air gap itself may serve as a dielectric. FIG. 10 shows a structure in which the upper surface and side surfaces of the conductive layer 103 are surrounded by a passivation layer 105, but a passivation layer may also exist on the lower surface of the conductive layer 103 in another embodiment. Additionally, a passivation layer may be disposed on any one of the upper surface, the side surfaces, and the bottom surface of the conductive layer 103.

The aforementioned interconnect structure can alleviate an increase in electrical resistance due to a decrease in the line width of wiring (e.g., conductive layer 103) due to high integration of semiconductor devices and can reduce or prevent defects caused by electromigration due to an increase in electrical resistance within the interconnect structure.

Hereinafter, a method for manufacturing the interconnect structure described above is described.

The method for manufacturing an interconnect structure 100a illustrated in FIG. 1 includes: forming a conductive layer 103 on a substrate; forming a dielectric layer including amorphous boron nitride (a-BN) on the conductive layer 103; and converting amorphous boron nitride (a-BN) existing at an interface between the dielectric layer and the conductive layer 103 into hexagonal boron nitride (h-BN) to form a passivation layer 105 including a first layer 105a including hexagonal boron nitride (h-BN) and a second layer 105b including amorphous boron nitride (a-BN). The first layer 105a may not include amorphous boron nitride (a-BN).

The method for manufacturing an interconnect structure 100b illustrated in FIG. 2 includes: forming a dielectric layer including amorphous boron nitride (a-BN) on a substrate; forming a conductive layer 103 on the dielectric layer; and converting amorphous boron nitride (a-BN) present at an interface between the dielectric layer and the conductive layer 103 into hexagonal boron nitride (h-BN) to form a passivation layer including a first layer 105a including hexagonal boron nitride (h-BN) and a second layer 105b including amorphous boron nitride (a-BN).

The method for manufacturing the interconnect structure 100c illustrated in FIG. 3 includes: forming a first dielectric layer including amorphous boron nitride (a-BN) on a substrate; forming a conductive layer 103 on the dielectric layer; forming a second dielectric layer including amorphous boron nitride (a-BN) on the conductive layer 103; and converting amorphous boron nitride (a-BN) present at the interface between the first dielectric layer and the conductive layer 103 into hexagonal boron nitride (h-BN) and converting amorphous boron nitride (a-BN) present at the interface between the second dielectric layer and the conductive layer 103 into hexagonal boron nitride (h-BN) to form a first passivation layer 105-1 including a first layer 105-1a including hexagonal boron nitride (h-BN) and a second layer 105-1b including amorphous boron nitride (a-BN) and a second passivation layer 105-2 including a first layer 105-2a including hexagonal boron nitride (h-BN) and a second layer 105-2b including amorphous boron nitride (a-BN). The first layer 105-1a and 105-2a may not include amorphous boron nitride (a-BN).

The conductive layer 103 and the dielectric layer of the interconnect structures 100a, 100b, and 100c may be formed by atomic layer deposition ("ALD"), chemical vapor deposition ("CVD"), or plasma enhanced CVD ("PECVD"), but the present disclosure is not limited thereto.

The process of converting amorphous boron nitride (a-BN) present at the interface between the dielectric layer (including the first dielectric layer and the second dielectric layer) and the conductive layer 103 into hexagonal boron nitride (h-BN) may include a process of locally applying energy to the amorphous boron nitride (a-BN) included in the dielectric layer.

The energy application process may include an annealing process, laser irradiation, or a combination thereof. The energy application process may be locally performed at the interface between the dielectric layer and the conductive layer, thereby minimizing damage to the device.

The annealing process may be a rapid thermal annealing ("RTA") process and may be performed at a temperature of about 800 °C to about 1000 °C for about 1 to about 10 minutes. For example, during the annealing process, the temperature may be greater than or equal to about 810 °C, for example, greater than or equal to about 820 °C, greater than or equal to about 830 °C, greater than or equal to about 840 °C, or greater than or equal to about 850 °C and may be less than or equal to about 1000 °C, for example, less than or equal to about 990 °C, less than or equal to about 980 °C, less than or equal to about 970 °C, less than or equal to about 960 °C, less than or equal to about 950 °C, less than or equal to about 940 °C, less than or equal to about 930 °C, less than or equal to about 920 °C, less than or equal to about 910 °C, or less than or equal to about 900 °C. Within the above range, amorphous boron nitride (a-BN) present at the interface between the dielectric layer and the conductive layer can be easily converted into hexagonal boron nitride (h-BN).

The laser irradiation may be performed by locally irradiating the interface between the dielectric layer and the conductive layer with a laser having a wavelength range of about 100 nm to about 1000 nm. The wavelength range of the laser may be greater than or equal to about 100 nm, for example, greater than or equal to about 200 nm, greater than or equal to about 300 nm, greater than or equal to about 400 nm, or greater than or equal to about 500 nm, and may be less than or equal to about 1000 nm, for example, less than or equal to about 950 nm, or less than or equal to about 900 nm. Within the above range, amorphous boron nitride (a-BN) present at the interface between the dielectric layer and the conductive layer can be easily converted into hexagonal boron nitride (h-BN).

By the above local energy application process, amorphous boron nitride (a-BN) included in the dielectric layer is used as a precursor material, and a metal included in the conductive layer acts as a catalyst, so that amorphous boron nitride (a-BN) present at the interface between the dielectric layer and the conductive layer is converted into hexagonal boron nitride (h-BN). As a result, a first layer including hexagonal boron nitride (h-BN) is formed at the interface between the dielectric layer and the conductive layer, which constitutes a passivation layer. The first layer including the hexagonal boron nitride (h-BN) may be formed as a continuous layer on the surface in contact with the conductive layer by applying local energy to the interface between the dielectric layer and the conductive layer. The first layer may be a monolayer of h-BN or a multilayer in which 2 to 5 monolayers are stacked. This may effectively suppress or reduce grain-boundary scattering and/or surface-roughness scattering effects.

The aforementioned interconnect structures 100a, 100b, 100c, 200a, 200b, 200c, 200d, 200e, 200f, and 300 may provide electronic devices. For example, the electronic device may include a semiconductor device, in which case the interconnect structures 100a, 100b, 100c, 200a, 200b, 200c, 200d, 200e, 200f, and 300 may be applied to Back End of Line ("BEOL") structure of the semiconductor device. The semiconductor device may include at least one of a transistor, a capacitor, a diode, or a resistor. In addition, the interconnect structures 100a, 100b, 100c, 200a, 200b, 200c, 200d, 200e, 200f, and 300 can be applied to various electronic devices.

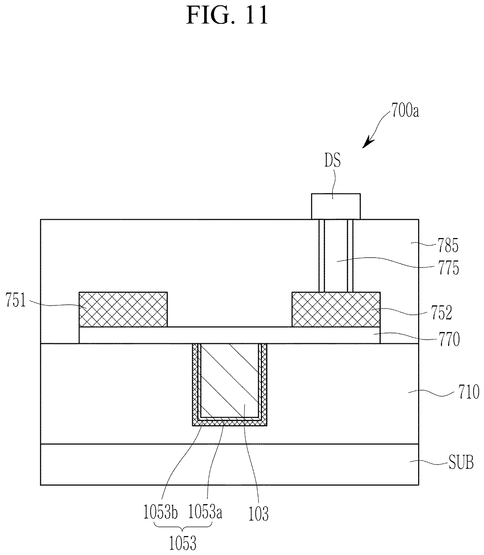

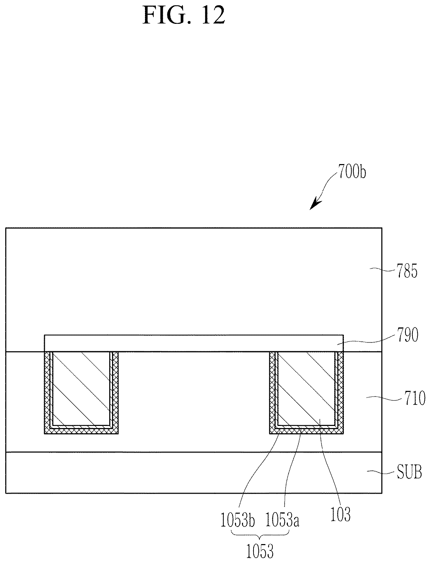

Hereinafter, an electronic device including the aforementioned interconnect structures will be described with reference to FIGS. 11 and 12.

FIGS. 11 and 12 are cross-sectional views of electronic devices according to some example embodiments.

Referring to FIG. 11, in an embodiment, the electronic device 700a may be formed of a transistor connected to data storage DS. The electronic device 700a may include a substrate SUB and an oxide dielectric layer 710. A conductive layer 103 and a passivation layer 1053 are present inside the trench of the oxide dielectric layer 710. The conductive layer 103 and the passivation layer 1053 may have the same structure as shown in FIG. 6. The conductive layer and passivation layer of FIG. 11 may be arranged in any one of the structures shown in FIGS. 4, 5, and 7 to 9.

The gate insulating layer 770 is disposed on the oxide dielectric layer 710. On the gate insulating layer 770, the source electrode 751 and the drain electrode 752 are arranged to be spaced apart from each other. The conductive layer 103 may be configured to operate as a gate electrode of the electronic device 700a.

The electronic device 700a may further include an insulating layer 785, such as silicon oxide, covering the source electrode 751, the gate insulating layer 770, and the drain electrode 752, and a data storage DS (e.g., a capacitor) may be on the insulating layer 785. Contact 775 including an electrically conductive material such as a metal or a metal alloy may connect data storage DS and drain electrode 752.

Referring to FIG. 12, in an embodiment, the electronic device 700b different from the electronic device 700a shown in FIG. 11 in that the gate insulating layer 770, the contact 775, the source electrode 751, the drain electrode 752, and the data storage DS are omitted. Additionally, the oxide dielectric layer 710 includes two trenches spaced apart from each other, and each of the trenches is formed in the same structure as the interconnect structure in FIG. 6. That is, each of the trenches may include a conductive layer 103 and a passivation layer 1053 formed therein.

An upper conductive layer 790 is formed on the oxide dielectric layer 710 and contacts the upper surface of the conductive layer 103 in each interconnect structure, so that the interconnect structures can be electrically connected to each other. The upper conductive layer 790 may include a conductive material such as a metal, a metal alloy, or a doped semiconductor. The conductive layer and passivation layer of FIG. 12 may be arranged in any one of the structures shown in FIGS. 4, 5, and 7 to 9.

Hereinafter, the embodiments are illustrated in more detail with reference to examples. However, the following examples are for illustrative purposes only and do not limit the scope of the rights.

### Example 1: Manufacturing of Stacked Structure for Test

An amorphous boron nitride thin film (dielectric layer, average thickness: 4.5 nm) is formed by depositing borazine on a SiO₂ (thickness: 100 nm)/Si (thickness: 725 micrometers (µm)) substrate using the ICP-CVD process at 400 °C for 25 minutes. Molybdenum is sputtered on the dielectric layer to form a conductive layer with a thickness of 200 nm. Then, rapid thermal annealing (RTA) is performed at 815 °C for 4 minutes to convert amorphous boron nitride (a-BN) present at the interface between the conductive layer and the dielectric layer into hexagonal boron nitride (h-BN) to form a passivation layer, thereby manufacturing the stacked structure for test.

### Example 2: Manufacturing of Stacked Structure for Test

A stacked structure is manufactured in the same manner as in Example 1, except that the RTA process is performed at 900 °C for 5 minutes.

### Example 3: Manufacturing of Stacked Structure for Test

A stacked structure is manufactured in the same manner as in Example 1, except that the RTA process is performed at 1000 °C for 1 minute.

### Comparative Example 1

An amorphous boron nitride thin film (dielectric layer, average thickness: 4.5 nm) is formed by depositing borazine on a Si (thickness: 525 µm) substrate using the ICP-CVD process at 400 °C for 25 minutes. Then, rapid thermal annealing (RTA) is performed at 900 °C for 5 minutes.

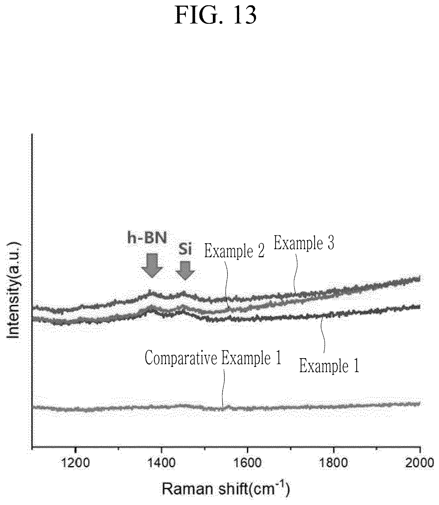

To confirm the formation of hexagonal boron nitride (h-BN) in the stacked structures according to Examples 1 to 3, Raman spectra are obtained after removing molybdenum and are shown in FIG. 13. For comparison, the Raman spectrum of the stacked structure according to Comparative Example 1 is also shown. FIG. 13 is a graph showing the results of Raman spectrum evaluations to confirm the formation of hexagonal boron nitride (h-BN) in structures according to Examples 1 to 3 and Comparative Example 1.

Referring to FIG. 13, peaks (1372 cm⁻¹) corresponding to hexagonal boron nitride (h-BN) are observed in the stacked structures according to Examples 1 to 3, while this peak is not observed in Comparative Example 1. From this, it can be confirmed that in the stacked structures according to Examples 1 to 3, hexagonal boron nitride (h-BN) converted from amorphous boron nitride (a-BN) of the dielectric layer is formed.

While this disclosure has been described in connection with what is presently considered to be practical example embodiments, it is to be understood that the invention is not limited to the disclosed embodiments, but, on the contrary, is intended to cover various modifications and equivalent arrangements included within the scope of the appended claims.

### <Description of symbols>

| | | | |
|---|---|---|---|
| 100a, 100b 100c, 200a, 200b, 200c, 200d, 200e, 200f, 300, | interconnect structure | | |
| 101, SUB: | substrate | 103: | conductive layer |
| 105, 105-1, 105-2, 1051, 1052, 1053: | passivation layer | | |
| 105a, 105-1a, 105-2a,1051a, 1052a, 1053a: | first layer | | |
| 105b, 105-1b, 105-2b, 1051b, 1052b, 1053b: | second layer | | |
| 700a, 700b: | electronic device | 710: | oxide dielectric layer |
| 770: | gate insulating layer | 751: | source electrode |
| 752: | drain electrode | DS: | data storage |
| 785: | insulating layer | 790: | upper conductive layer |

## Claims

1. An interconnect structure, comprising
a substrate,
a conductive layer on the substrate, and
a passivation layer in contact with the conductive layer,
wherein the passivation layer comprises a first layer comprising hexagonal boron nitride (h-BN) having a hexagonal crystal structure and a second layer comprising amorphous boron nitride (a-BN), and
the first layer is in contact with the conductive layer.

2. The interconnect structure of claim 1, wherein
the passivation layer is disposed on at least one of an upper surface or a lower surface of the conductive layer.

3. The interconnect structure of claim 1 or 2, wherein
the conductive layer comprises a metal, a metal alloy, a conductive compound, or a combination thereof, and optionally wherein
the metal comprises a transition metal, a Group 2A metal, a Group 3A (Group 13) metal, or a combination thereof.

4. The interconnect structure of any preceding claim, wherein
the conductive layer has a thickness of greater than or equal to 0.1 nanometers (nm) and less than or equal to 10 nm, and the passivation layer has a thickness of greater than or equal to 0.1 nm and less than or equal to 30 nm.

5. The interconnect structure of any preceding claim, wherein
a thickness ratio of the conductive layer and passivation layer is in a range of 1:0.01 to 1:3.

6. The interconnect structure of any preceding claim, wherein
the hexagonal boron nitride (h-BN) included in the first layer is derived from amorphous boron nitride (a-BN) included in the second layer.

7. The interconnect structure of any preceding claim, wherein
the hexagonal boron nitride (h-BN) included in the first layer forms van der Waals bonds with a material constituting the conductive layer.

8. The interconnect structure of any preceding claim, wherein
the first layer has a thickness of greater than or equal to 0.1 nm and less than or equal to 3 nm, and the second layer has a thickness of greater than or equal to 0.5 nm and less than or equal to 25 nm.

9. The interconnect structure of any preceding claim, wherein
a thickness ratio of the first layer and the second layer is in a range of 1:1.5 to 1:8.

10. The interconnect structure of any preceding claim, wherein
the substrate comprises a dielectric layer defining a trench structure therein,
the conductive layer fills an interior of the trench structure, and
the passivation layer is disposed on an upper surface of the conductive layer.

11. The interconnect structure of any preceding claim, wherein
the substrate comprises a dielectric layer defining a trench structure therein,
the conductive layer fills an interior of the trench structure, and
the passivation layer either: surrounds an entirety of the conductive layer; or is disposed on a lower surface and side surfaces of the conductive layer.

12. An electronic device comprising the interconnect structure of any preceding claim, and optionally wherein the electronic device is a transistor, a capacitor, a diode, or a resistor.

13. A method for manufacturing an interconnect structure, comprising
forming a conductive layer on a substrate;
forming a dielectric layer comprising amorphous boron nitride (a-BN) on the conductive layer; and
converting amorphous boron nitride (a-BN) present at an interface between the dielectric layer and the conductive layer into hexagonal boron nitride (h-BN) to form a passivation layer comprising a first layer comprising the hexagonal boron nitride (h-BN) and a second layer comprising amorphous boron nitride (a-BN).

14. A method of manufacturing the interconnect structure, comprising
forming a dielectric layer comprising amorphous boron nitride (a-BN) on a substrate;
forming a conductive layer on the dielectric layer; and
converting amorphous boron nitride (a-BN) present at an interface between the dielectric layer and the conductive layer into hexagonal boron nitride (h-BN) to form a passivation layer comprising a first layer comprising the hexagonal boron nitride (h-BN) and a second layer comprising amorphous boron nitride (a-BN).

15. The method of claim 13 or 14, wherein
the passivation layer is formed by a process of locally applying energy to the amorphous boron nitride (a-BN) included in the dielectric layer to convert it into the hexagonal boron nitride (h-BN) included in the first layer, and optionally wherein
the passivation layer is formed by a process of locally applying energy to the amorphous boron nitride (a-BN) included in the dielectric layer to convert it into the hexagonal boron nitride (h-BN) included in the first layer.
